# EUROPÄISCHE PATENTSCHRIFT

(11) **EP 2 801 915 B1**
(45) Veröffentlichungstag und Bekanntmachung des Hinweises auf die Patenterteilung: **18.01.2017**
(21) Anmeldenummer: 13167208.1
(22) Anmeldetag: 10.05.2013
(51) Int. Cl.: G06F 13/42, G05B 19/042

(54) **ADAPTIVES INTERFACE ZUR KOPPLUNG VON FPGA-MODULEN**
ADAPTIVE INTERFACE FOR COUPLING OF FPGA MODULES
INTERFACE ADAPTATIVE POUR LE COUPLAGE DE MODULES FPGA

(43) Veröffentlichungstag der Anmeldung: 12.11.2014
(73) Patentinhaber: dSPACE digital signal processing and control engineering GmbH, 33102 Paderborn (DE)
(72) Erfinder: Hasse, Dirk, 33154 Salzkotten (DE); Polnau, Robert, 33098 Paderborn (DE)
(74) Vertreter: Michalski Hüttermann & Partner Patentanwälte mbB

(56) Entgegenhaltungen:
- EP-A1- 1 168 187
- DE-A1-102011 052 512
- DE-U1- 20 307 308
- JP-A- H04 322 347
- US-B1- 7 268 582

## Beschreibung

Die vorliegende Erfindung betrifft ein Verfahren zur Implementierung eines Interface zwischen wenigstens einem FPGA mit wenigstens einer FPGA-Applikation und wenigstens einem I/O-Modul zur Verbindung mit dem FPGA, die als korrespondierende Senderseite bzw. Empfängerseite ausgebildet sind. Weiterhin betrifft die Erfindung ein FPGA-Steuerungssystem mit wenigstens einem FPGA mit wenigstens einer FPGA-Applikation und wenigstens einem I/O-Modul zur Verbindung mit dem FPGA, die als korrespondierende Senderseite bzw. Empfängerseite ausgebildet sind.

Bei High-End Anwendungen werden zunehmend geringere ZyklusZeiten von Regelkreis-Modellen gefordert. Daher werden solche Regelkreis-Modelle basierend auf Regel-Algorithmen häufig in FPGA-Steuerungssystemen auf Field Programmable Gate Arrays (FPGAs) implementiert, wodurch sehr schnelle Regelkreise mit Abtastraten von 100ns bis 5µs implementiert werden können. Die Regelkreis-Modelle können dabei modular ausgestaltet sein. Diese modularen FPGA-Schaltungen bzw. Modell-FPGA-Schaltungen verfügen bei Prototyping Systemen in der Regel nicht über eine passende I/O-Beschaltung, um benötigte Sensoren und/oder Aktoren direkt ansprechen zu können.

Somit ist eine Adaptierung für die Sensoren und/oder Aktoren erforderlich, welche über I/O-Module erfolgt. Die I/O-Module können beispielsweise über ein Stecksystem eine Verbindung zur Modell-Hardware, d.h. dem FPGA, herstellen, wobei direkte Stecker zum Aufstecken der I/O-Module oder Kabelstecker verwendet werden können.

Problematisch ist bei einem derartigen modularen System, beliebige I/O-Module mit geringer Latenz und hoher Bandbreite an das Modell-FPGA anzubinden.

Um dieses Problem zu lösen ist im Stand der Technik bekannt, für jedes spezifische I/O-Modul eine geeignete Schnittstelle mit einem geeigneten Protokoll zu definieren. Dadurch kann eine geringe Latenz bei möglichst hoher Bandbreite erreicht werden. Allerdings muss jede definierte Schnittstelle spezifisch sowohl auf Seite der FPGA-Applikation wie auch für das jeweilige I/O-Modul erstellt werden, was mit großem Aufwand verbunden ist.

Alternativ ist im Stand der Technik bekannt modulare Busse zu implementieren, die in der Regel eine feste maximal erreichbare Bandbreite und Latenz aufweisen. Es sind unterschiedliche modulare Systeme bekannt, bei denen die Anbindung über Adress-Daten-Busse erfolgt. Dabei wird prinzipiell zwischen parallelen Bussen, z.B. PHS-Bus oder ISA-Bus, und seriellen Bussen, z.B. PCIExpress, unterschieden.

Bei den parallelen Bussen wird die Bandbreite in der Regel durch die Anzahl der vorhandenen Datenleitungen bestimmt. Bei einem Bus mit N Datenleitungen ist die Latenz bei der Übertragung von 1 oder N Bit identisch. Die maximal erreichbare Bandbreite und Latenz ist für alle I/O-Module identisch.

Bei seriellen Bussen für modulare Systeme wird ein Protokoll verwendet, in das die eigentlichen Nutzdaten eingebettet werden. Diese bekannten Protokolle haben einen Mindest-Protokoll-Overhead, der unabhängig zur Übertragung von bspw. 1 Bit oder 32 Bit identisch ist, wenn durch das Protokoll eine Mindest-Nutzdatenmenge festgelegt ist. Beispielsweise können immer nur n*Bytes (8 Bit) oder n*32Bit übertragen werden. Soll nur ein Nutzdaten-Bit übertragen werden, muss trotzdem die komplette Mindest-Nutzdatenmenge übertragen werden. Durch den Protokoll-Overhead und die Mindest-Nutzdatenmenge verschlechtern sich die Bandbreite und die Latenz im Vergleich zu einer spezifischen Implementierung der Schnittstelle.

Auch kann abhängig von den verwendeten FPGA-Modellen eine konstante Datenrate erforderlich sein. Abweichungen von der konstanten Datenrate werden als Jitter bezeichnet.

Die obigen Ausführungen betreffen jeweils eine Sender- und eine Empfängerseite, d.h. ein unidirektionales Interface. Eine Implementierung der FPGA-Applikation und des I/O-Modul als Sender- bzw. Empfängerseite ist dabei austauschbar. Darüber hinaus kann das Interface auch als bidirektionales Interface ausgeführt sein.

In diesem Zusammenhang ist aus der DE 203 07 308 U1 ein Steuergerät für Steuerungsaufgaben im untertägigen Bergbau mit einer modular aufgebauten Hardware bekannt. Das Steuergerät umfasst eine Zentraleinheit mit Mikroprozessor und zugeordneten, programmierbaren Speicherbausteinen zum Speichern und Verarbeiten von Software und mit einer Anschlußbaugruppe zur Kommunikation des Steuergerätes mit anderen Steuergeräten und/oder den anzusteuernden Aktoren, Sensoren u. dgl.. Die Zentraleinheit und die Anschlußbaugruppe sind als Module ausgeführt, wobei für die Zentraleinheit und die Anschlußbaugruppe Module mit unterschiedlichen Leistungsmöglichkeiten und/oder Funktionalitäten vorgesehen sind, die nach einem Baukastenprinzip zur Hardware eines Steuergerätes miteinander kombinierbar und koppelbar sind.

Auch ist aus der EP 1 168 187 A1 ist ein allgemeines Verfahren zu seriellen Datenübertragung bekannt. Nach diesem Verfahren wird in einem Block-Modus eine Übertragung von Speicherblöcken durchgeführt, wenn diese zur Übertragung markiert sind.

Ausgehend von dem oben genannten Stand der Technik liegt der Erfindung somit die Aufgabe zugrunde, einen oben angegebenes Verfahren sowie ein FPGA-Steuerungssystem der oben genannten Art anzugeben, die eine variable Datenübertragung zwischen Sender- und Empfängerseite mit einer gewünschten Datenrate und einer gewünschten Latenz unter Bereitstellung einer hohen Datenrate und einer niedrigen Latenz ermöglichen und mit geringem Aufwand durchzuführen bzw. bereitzustellen sind.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Erfindungsgemäß ist somit ein Verfahren zur Implementierung eines adaptiven Interface zwischen wenigstens einem FPGA mit wenigstens einer FPGA-Applikation und wenigstens einem I/O-Modul zur Verbindung mit dem FPGA, die als korrespondierende Senderseite bzw. Empfängerseite ausgebildet sind, angegeben. Zwischen dem wenigstens einen FPGA und dem wenigstens einen I/O-Modul ist eine serielle Schnittstelle ausgebildet. Das Verfahren umfasst die Schritte Konfigurieren einer maximalen Anzahl von zu übertragenden Registern für jede FPGA-Applikation, Konfigurieren einer gemeinsamen, festen Registerbreite für alle Register, Setzen eines Enable-Signals auf der Senderseite für zu übertragende Register aus der maximalen Anzahl von zu übertragenden Registern, Übertragen des Enable-Signals von der Senderseite zu der Empfängerseite über die serielle Schnittstelle, Übertragen der Register, für welche das Enable-Signal gesetzt ist, von der Senderseite zu der Empfängerseite über die serielle Schnittstelle.

Erfindungsgemäß ist weiterhin ein FPGA-Steuerungssystem mit wenigstens einem FPGA mit wenigstens einer FPGA-Applikation und wenigstens einem I/O-Modul zur Verbindung mit dem FPGA, die als korrespondierende Senderseite bzw. Empfängerseite ausgebildet sind, angegeben. Zwischen dem wenigstens einen FPGA und dem wenigstens einen I/O-Modul ist eine serielle Schnittstelle ausgebildet. Das FPGA-Steuerungssystem ist zur Implementierung eines adaptiven Interface zwischen dem wenigstens einen FPGA und dem wenigstens einem I/O-Modul nach dem obigen Verfahren ausgebildet.

Grundidee der vorliegenden Erfindung ist es also, durch die Bereitstellung eines adaptiven Interface zwischen der FPGA-Applikation und dem I/O-Modul eine einfache Implementierung zu ermöglichen, indem Standard-Implementierungen verwendet und jeweils für den gewünschten Bedarf konfiguriert werden können. Durch die Konfiguration werden nur die Daten durch das adaptive Interface übertragen, die für die konkrete Anwendung einer I/O-Funktion relevant sind. Durch die Konfiguration von der maximalen Anzahl von zu übertragenden Registern für jede FPGA-Applikation und der gemeinsamen, festen Registerbreite kann eine einfache Anpassung von FPGA-Applikationen und I/O-Modulen an unterschiedliche FPGA-Funktionen erfolgen, um einfach Steuerungs- und Regelsysteme mit einer hohen Effizienz bereitzustellen.

Vorzugsweise umfasst das Konfigurieren einer maximalen Anzahl von zu übertragenden Registern für jede FPGA-Applikation und das Konfigurieren einer gemeinsamen, festen Registerbreite für alle Register die Auswahl einer Anzahl von maximal zu übertragenden Registern für jedes FPGA-Modell sowie eine maximal zu übertragende Anzahl von Bits eines Registers. Diese Konfiguration ist vorzugsweise eine globale Konfiguration für alle FPGA-Applikation. Das FPGA-Modell betrifft dabei die Gesamtheit aller FPGA-Applikation, wobei das FPGA-Modell eine Mehrzahl einzelner Modelle aufweisen kann.

Das Setzen des Enable-Signals auf der Senderseite bewirkt das Nicht-Übertragen von Daten von nicht genutzten Registern, wodurch die verfügbare Bandbreite effizient genutzt werden kann. Darüber hinaus kann die Nutzung der Bandbreite dynamisch angepasst werden, so dass für kleine Datenmengen eine geringe Latenz erreicht werden kann. So kann mit demselben adaptiven Interface die Bereitstellung von hohen Datenraten wie auch einer geringen Latenz realisiert werden. Entsprechend können sowohl Anwendungen mit geringster Latenz auf wenigen Kanälen als auch solche mit hoher Kanalzahl zuverlässig und einfach realisiert werden. Dabei sind nur wenige Konfigurationsparameter vorzugeben, wodurch die Nutzung des adaptiven Interface einfach und komfortabel möglich ist.

Die Anzahl der im FPGA implementierten Register richtet sich zur Generierungszeit des FPGA-Codes nach den Erfordernissen der jeweils gewählten I/O-Funktion des FPGA-Modells und/oder des I/O-Moduls. FPGA-Ressourcen, die für die Implementierung der I/O-Funktion erforderlich sind, können anhand der Konfiguration angepasst werden. Bei statisch festgelegten Enable-Signalen können die FPGA-Ressourcen anhand der nicht genutzten Register weiter optimiert werden. Wird beispielsweise nur ein Register benötigt, reduzieren sich die FPGA-Ressourcen auf ein Minimum. Die Anzahl der Bits in den Registern einer FPGA-Applikation sind dabei gleichbedeutend mit Eingängen der Senderseite.

Vorzugsweise werden die Enable-Signale bei einer Übertragungsrichtung von der FPGA-Applikation zu dem I/O-Modul automatisch aktiviert, sobald ein Datenkanal im dem zugrundeliegenden FPGA Modell verwendet wird. Entsprechendes gilt für die Enable-Signale bei einer Übertragungsrichtung von dem I/O-Modul zu der FPGA-Applikation, die durch die Implementierung des I/O-Module in dem FPGA-Modell automatisch gesetzt werden können.

Vorzugsweise werden ungenutzte Bits in Registern auf einen konstanten Wert gesetzt. Durch diesen vordefinierten Wert wird die Handhabung erleichtert.

Die serielle Schnittstelle ist vorzugsweise als LVDS-Interface ausgeführt, das eine hohe Datenübertragungsrate ermöglicht. Durch Parallelschalten von mehreren LVDS-Interfaces kann die Bandbreite flexibel erhöht werden. Das LVDS-Interface ist üblicherweise zur Übertragung von Datenblöcken mit einer fixen Länge ausgeführt, beispielsweise 8 Bit. Vorzugsweise wird die Länge der Datenblöcke des LVDS-Interface als Konfigurationseinstellung konfiguriert. Vorzugsweise ist die Anzahl der Bits eines Registers derart gewählt, dass sie zusammen mit einem Overhead zur Signalisierung ein Vielfaches der Länge des Datenblocks des LVDS-Interface ist. Beispielsweise kann jedes Register 34 Bit umfassen, die zusammen mit 6 Bit Overhead in insgesamt fünf Datenblöcken des LVDS-Interface übertragen werden.

Das verwendete physikalische Interface zwischen dem FPGA und dem I/O-Modul, d.h. die serielle Schnittstelle, wird also durch ein übergeordnetes Protokoll abstrahiert. Abstrahierte Komponenten des übergeordneten Protokolls können einfach in weitere Module und Modelle integriert werden, beispielsweise per Blockset oder IP-Cores und/oder Netzlisten. Das adaptive Interface erlaubt aufgrund der Generik die Kopplung verschiedenartiger I/O-Module. Dabei ist lediglich erforderlich, dass die Konfiguration der Schnittstelle gleichartig ist. Vorzugsweise erfolgt eine entsprechende Konfiguration der Schnittstelle initial für alle I/O-Module, wodurch die gemeinsame Verwendung sichergestellt werden kann. Üblicherweise bilden eine Mehrzahl Register des FPGA jeweils einen Port ab.

Die obigen Ausführungen betreffen jeweils eine Sender- und eine Empfängerseite, d.h. ein unidirektionales Interface. Eine Implementierung der FPGA-Applikation und des I/O-Modul als Sender- bzw. Empfängerseite ist dabei austauschbar. Darüber hinaus kann das Interface auch als bidirektionales Interface ausgeführt sein.

In vorteilhafter Ausgestaltung der Erfindung umfasst das Übertragen der Register, für welche das Enable-Signal gesetzt ist, von der Senderseite zu der Empfängerseite das Bereitstellen eines Strobe-Signals auf der Senderseite, um anzuzeigen, dass die zu übertragenden Register zur Übertragung bereit sind. Das Strobe-Signal wird vorzugsweise von auf der Senderseite von dem Modell gesetzt um anzuzeigen, dass die Daten in den Registern konsistent sind und eine Übertragung gestartet werden kann. Das Strobe-Signal ist vorzugsweise als einzelnes Bit ausgeführt. Das Strobe-Signal signalisiert der Senderseite das Anliegen von Daten in den Registern für die Übertragung über die serielle Schnittstelle. Somit können diese Daten beginnend mit dem Strobe-Signal auf der Senderseite aus den Registern ausgelesen und übertragen werden, um sie auf der Empfängerseite in die passenden Register einschreiben. Die Senderseite kann anhand des Strobe-Signals sicher davon ausgehen, dass alle Register datenkonsistent zueinander übermittelt werden. Prinzipiell kann durch das Strobe-Signal eine Synchronisation von einer Mehrzahl I/O-Module erfolgen.

In vorteilhafter Ausgestaltung der Erfindung umfasst das Übertragen der Register, für welche das Enable-Signal gesetzt ist, von der Senderseite zu der Empfängerseite das Bereitstellen eines Ready-Signals auf der Senderseite, um anzuzeigen, dass die Übertragung der Register an die Empfängerseite abgeschlossen ist. Über das Ready-Signal wird also auf Senderseite dem FPGA-Modell der erfolgreiche Abschluss der Übertragung signalisiert, sodass dieses die Register neu füllen kann für eine Übertragung weiterer Daten. Mit dem Abschluss der Übertragung geht somit die Bereitschaft zu einer erneuten Übertragung einher. Das Ready-Signal ist vorzugsweise als einzelnes Bit ausgeführt. Sollen von der Senderseite Daten aus den Registern versendet werden, wird zunächst der Zustand des Ready-Signals überprüft. Läuft bereits eine Übertragung, wird dies durch das fehlende Ready-Signal angezeigt, und eine Datenübertragung ist nicht möglich. Vorzugsweise wird das Ready-Signal erst aktiviert, nachdem das Interface initialisiert ist, d.h. zumindest die Enable-Signale von der Senderseite an die Empfängerseite übermittelt worden sind. Sobald das Ready-Signal den Versand der Daten erlaubt, stößt die FPGA-Applikation die Übermittlung an. Dadurch kann die Schnittstelle mit einer geringen Latenz aus einem Idle State, in dem keine Datenübertragung erfolgt, eine Datenübertragung beginnen.

In vorteilhafter Ausgestaltung der Erfindung umfasst das Übertragen der Register, für welche das Enable-Signal gesetzt ist, von der Senderseite zu der Empfängerseite das Bereitstellen eines Ready-Signals auf der Empfängerseite, um anzuzeigen, dass das Empfangen der Register von der Senderseite abgeschlossen ist. Dadurch kann auf der Empfängerseite eine jeweilige Hardware-Implementierung aus den übertragenen Registern die für sie bestimmten Daten auslesen. Eine Verzögerung beim Auslesen wird verhindert, so dass eine nachfolgende Übertragung weiterer Daten ebenfalls nicht verzögert wird.

Die Implementierung von Strobe- und/oder Ready-Signal kann beliebig als High- oder Low-Pegel erfolgen, d.h. als Null oder Eins.

In vorteilhafter Ausgestaltung der Erfindung umfasst das Übertragen der Register, für welche das Enable-Signal gesetzt ist, von der Senderseite zu der Empfängerseite das Aussparen gleichartiger Führungsbits jedes Registers. Somit kann die insgesamt zu übertragende Datenmenge um die Anzahl gleichartiger Führungsbits reduziert werden. Prinzipiell kann dabei eine Implementierung gewählt werden, die nach Bedarf führende Nullen oder Einsen als gleichartige Führungsbits erfasst und ausspart, d.h. in einer Implementierung werden führende Einsen als gleichartige Führungsbits erfasst, während in einer anderen Implementierung führende Nullen als gleichartige Führungsbits erfasst werden. Auf Empfängerseite können nicht empfangene Bits, d.h. die ausgesparten Bits, als Bits mit dem Wert der gleichartigen Führungsbits ergänzt werden. Die Art der gleichartigen Führungsbits kann vorzugsweise konfiguriert werden.

Alternativ kann ein komplettes Register übertragen werden, was über ein entsprechendes Kontrollsignal für jedes einzelne Register signalisiert werden kann.

In vorteilhafter Ausgestaltung der Erfindung umfasst das Aussparen gleichartiger Führungsbits jedes Registers das Aussparen von vordefinierten Registerabschnitten mit gleichartigen Führungsbits. Es werden also nur gleichartige Führungsbits ausgespart, wenn der ganze Registerabschnitt die gleichartigen Führungsbits beinhaltet. Somit muss eine Anzahl Führungsbits, die einer Länge des Registerabschnitts entspricht, gleichartig sein, um die Übertragung dieser Führungsbits auszusparen. Vorzugsweise ist die Länge der vordefinierten Registerabschnitte derart gewählt, dass sie der Länge von Übertragungsblöcken der seriellen Schnittstelle entspricht. Besonders bevorzugt ist die Länge der vordefinierten Registerabschnitte derart gewählt, dass sie der Länge von Übertragungsblöcken des LVDS-Interface entspricht. Dabei kann die Länge der Registerabschnitte derart gewählt sein, dass die Länge des Registerabschnitts zusammen mit einem Overhead zur Signalisierung der Länge eines Übertragungsblocks entspricht. Ein Übertragungsblock wird dabei jeweils vollständig bzw. im Wesentlichen vollständig für einen vordefinierten Registerabschnitt genutzt. Die Größe der vordefinierten Registerabschnitte kann als globaler Wert definiert sein, oder dynamisch während der Ausführung des FPGA-Modells angepasst werden. Dadurch kann die Datenübermittlung beschleunigt werden, indem Übertragungsblöcke der seriellen Schnittstelle eingespart werden.

Alternativ kann ein kompletter Registerabschnitt übertragen werden, was über ein entsprechendes Kontrollsignal für jeden einzelnen Registerabschnitt signalisiert werden kann.

In vorteilhafter Ausgestaltung der Erfindung umfasst das Übertragen der Register, für welche das Enable-Signal gesetzt ist, von der Senderseite zu der Empfängerseite das Hinzufügen eines Führungsbits als nicht gleichartiges Bit. Dies erzwingt die Übertragung des gesamten Registers, so dass das Interface mit einer konstanten Datenrate arbeitet. Entsprechend kann ein Jitter der Datenübertragung reduziert bzw. vermieden werden.

In vorteilhafter Ausgestaltung der Erfindung umfasst das Übertragen der Register, für welche das Enable-Signal gesetzt ist, von der Senderseite zu der Empfängerseite das Überprüfen von Registern, für welche das Enable-Signal gesetzt ist, auf geänderte Inhalte und das Übertragen von Registern mit geänderten Inhalten. Prinzipiell können die geänderten Register wie vorliegend übermittelt werden. Vorzugsweise werden jedoch nur die Änderungen übertragen. Somit kann in Fällen, in denen die Bits eines Registers nicht geändert werden, die Änderung beispielswese als Null übertragen werden, während ein geändertes Bit beispielswese als Eins übertragen wird. In Kombination mit einem Aussparen der Übertragung von gleichartigen, führenden Bits, in dem vorliegenden Fall Nullen, kann somit die Übertragung von nicht geänderten Registerinhalten auch bei einer beliebigen Kodierung mit Nullen und Einsen ausgespart werden. Damit wird beispielsweise bei einem System mit sich selten ändernden Signalen, die Führungsbits darstellen, eine Reduktion der zu übertragenden Daten ermöglicht, auch wenn dieses Signal nicht dem gleichartigen Bit, d.h. Null oder Eins, entspricht. Somit müssen nicht alle Bits des Registers wegen eines nicht gleichartigen Führungsbits übertragen werden.

In vorteilhafter Ausgestaltung der Erfindung umfasst das Verfahren das Synchronisieren von Registerinhalten auf der Sender- und der Empfängerseite. Das Synchronisieren kann periodisch, innerhalb von zeitlichen Grenzen und/oder eventbezogen erfolgen, um die Integrität der Daten auf Empfängerseite sicherzustellen oder zu überprüfen. Dazu werden die Daten wie sie im Register vorliegen übertragen, d.h. es werden die Register vollständig übertragen. Dies wird über ein entsprechendes Kontrollsignal für jedes einzelne Register signalisiert. Vorzugsweise werden in einem Normalbetrieb Änderungen der Registerinhalte übertragen, wobei die Synchronisation die Integrität der Registerinhalte, d.h. den Abgleich der Registerinhalte der Senderseite und der Empfängerseite, gewährleistet. Besonders bevorzugt wird das Synchronisieren periodisch durchgeführt.

In vorteilhafter Ausgestaltung der Erfindung umfasst das Setzen auf der Senderseite eines Enable-Signals für zu übertragende Register aus der maximalen Anzahl von zu übertragenden Registern ein dynamisches Setzen des Enable-Signals vor der Übertragung der Register, und das Übertragen des Enable-Signals von der Senderseite zu der Empfängerseite erfolgt jeweils vor der Übertragung der Register. Beispielsweise kann das Enable-Signal vor jeder Datenübertragung an die Empfängerseite übertragen werden. Dadurch wird eine hohe Flexibilität des adaptiven Interface erreicht.

In vorteilhafter Ausgestaltung der Erfindung umfasst das Setzen auf der Senderseite eines Enable-Signals für zu übertragende Register aus der maximalen Anzahl von zu übertragenden Registern ein dynamisches Setzen des Enable-Signals bei einer Veränderung zu übertragender Register, und das Übertragen des Enable-Signals von der Senderseite zu der Empfängerseite erfolgt jeweils nach einer Veränderung der zu übertragenden Register. Somit kann das Enable-Signal beispielsweise beim Systemstart an die Empfängerseite übertragen werden. Änderungen des Enable-Signals werden nur bei Bedarf übertragen. Damit erfordert die Übertragung des Enable-Signals nur wenig Ressourcen und wirkt sich nur geringfügig auf den Datendurchsatz bzw. die Latenz aus.

In vorteilhafter Ausgestaltung der Erfindung erfolgt das Übertragen des Enable-Signals von der Senderseite zu der Empfängerseite in einer Übertragungspause auf der seriellen Schnittstelle. Die Änderungen des Enable-Signals und eine damit einhergehende Änderung der Konfiguration werden also durchgeführt, wenn die Schnittstelle in einem IDLE-Mode keine Daten überträgt. Damit erfordert die Übertragung des Enable-Signals nur wenig Ressourcen und wirkt sich nur geringfügig auf den Datendurchsatz bzw. die Latenz aus.

Prinzipiell ist im IDLE-Mode auch eine wiederholte Übertragung des Enable-Signals möglich, wenn sich dieses nicht geändert hat.

In vorteilhafter Ausgestaltung der Erfindung umfasst das Verfahren den zusätzlichen Schritt des Hinzufügens eines generischen Funktionsblocks zur Senderseite wie auch zur Empfängerseite. Somit wird beispielsweise in der FPGA-Applikation ein Blockset-"Block" in das Modell integriert. Dieser Block kann für alle spezifischen I/O-Module identisch gehalten sein. Optional wird anstelle eines Blockset-Blocks ein (V)HDL-IP-Core in den (V)HDL-Quellcode eines Anwender-Modells integriert oder als Netzliste in das Anwender-Design integriert. Weiter bevorzugt kann der Funktionsblock als Block für eine grafische Programmierung hinzugefügt werden, wodurch die Programmierung einfach realisiert werden kann.

In vorteilhafter Ausgestaltung der Erfindung umfasst das Verfahren den zusätzlichen Schritt des automatischen Ermittelns eine Konfiguration für das adaptive Interface. Die automatische Konfiguration umfasst die maximale Anzahl von zu übertragenden Registern für jede FPGA-Applikation, sowie der gemeinsamen, festen Registerbreite für alle Register. Optional kann auch eine automatische Konfiguration für die Länge der vordefinierten Registerabschnitte erfolgen. Basis für die automatische Konfiguration ist vorzugsweise eine Blockgröße für die Übertragung von Daten über die serielle Schnittstelle. Durch die automatische Konfiguration wird sichergestellt, dass eine optimale Bandbreite und/oder Latenz erreicht wird.

Nachfolgend wird die Erfindung unter Bezugnahme auf die anliegende Zeichnung anhand bevorzugter Ausführungsformen näher erläutert.

Es zeigen
- Fig. 1: eine schematische Darstellung eines FPGA-Steuerungssystems mit einem FPGA und zwei mit dem FPGA über eine serielle Schnittstelle verbundenen I/O-Modulen gemäß einer bevorzugten Ausführungsform,
- Fig. 2: eine Detailansicht des FPGA-Steuerungssystems aus Fig. 1,

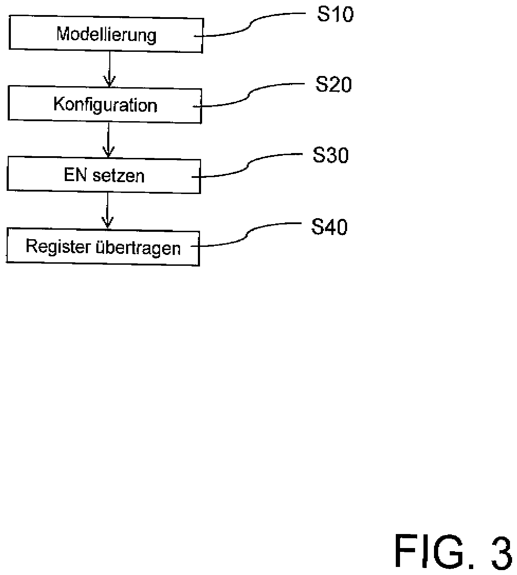

- Fig. 3: ein Blockdiagramm eines Verfahrens zur gemäß einer bevorzugten Ausführungsform, und
- Fig. 4: ein Diagramm zur Veranschaulichung der Funktion des adaptiven Interface.

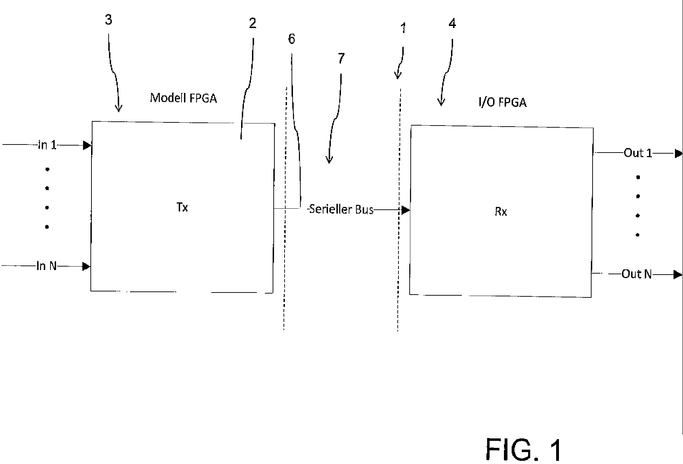

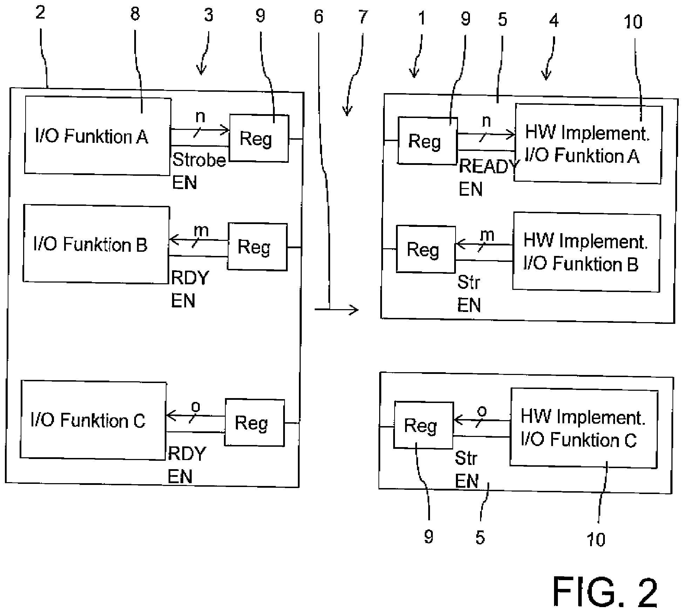

Die Figur 1 zeigt ein FPGA-Steuerungssystem 1 gemäß einer bevorzugten Ausführungsform. Das FPGA-Steuerungssystem 1 umfasst ein FPGA 2 als Senderseite 3 und eine Empfängerseite 4. Die Empfängerseite 4 umfasst in diesem Ausführungsbeispiel zwei I/O-Module 5, wie in Fig. 2 im Detail gezeigt ist.

Zwischen Senderseite 3 und der Empfängerseite 4 ist eine serielle Schnittstelle 6 ausgebildet ist. Die serielle Schnittstelle 6 ist die Basis für ein adaptives Interface 7, das zwischen dem FPGA 2 und den I/O-Modulen 5 implementiert ist und die serielle Schnittstelle 6 als Übertragungsmedium nutzt. Die serielle Schnittstelle 6 ist als LVDS-Interface mit einer Blockgröße von 8 Bit für die Übertragung von Daten ausgeführt.

Auf dem FPGA 2 ist eine Mehrzahl FPGA-Applikationen 8 implementiert, die jeweils über Register 9 mit dem adaptiven Interface 7 verbunden sind. Auf Empfängerseite 4 sind eine Mehrzahl Hardware-Implementierungen 10 auf den I/O-Modulen 5 ausgebildet, die ebenfalls über Register 9 mit dem adaptiven Interface 7 verbunden sind.

Im Weiteren wird ein Verfahren zur Implementierung des adaptiven Interface 7 zwischen dem FPGA 2 und den I/O-Modulen 5 beschrieben.

Zunächst wird in einem Schritt S10 eine Modellierung der FPGA-Applikationen 8 und der Hardware-Implementierungen 10 durchgeführt. Dabei werden jeweils generische Funktionsblocks zur Senderseite 3 wie auch zur Empfängerseite 4 als Blockset-Block in das jeweilige Modell integriert. Dieser Blockset-Block ist für alle spezifischen I/O-Module 5 identisch. Das Hinzufügen des Blockset-Blocks erfolgt als grafische Programmierung.

In einem Schritt S20 erfolgt ein automatisches Ermitteln einer Konfiguration für das adaptive Interface 7. Die automatische Konfiguration umfasst die maximale Anzahl von zu übertragenden Registern 9 für jede FPGA-Applikation 8, sowie der gemeinsamen, festen Registerbreite für alle Register 9. Die Konfiguration erfolgt auf Basis der Blockgröße für die Übertragung von Daten über die serielle Schnittstelle 6. In diesem Ausführungsbeispiel sind die FPGA-Applikation 8 mit n, m, o Registern 9 ausgeführt, wobei die Anzahl n, m, o der Register 9 jeweils auf 12 gesetzt und die Registerbreite als 34 Bit gewählt ist. Von Registern 9 genutzte Bits beginnen mit Bit Nummer 0 und werden dann aufsteigend bis zu Bit B-1 belegt. Ungenutzte Bits in Registern 9 werden auf den konstanten Wert "Null" gesetzt. Die Anzahl der im FPGA 2 implementierten Register 9 wird dabei zur Generierungszeit des FPGA-Codes nach den Erfordernissen der jeweils gewählten I/O-Funktion der FPGA-Applikationen 8 und der I/O-Module 5 gewählt. Die Anzahl der Bits in den Registern 9 der FPGA-Applikationen 8 sind dabei gleichbedeutend mit Eingängen (Ports) der Senderseite 3.

In einer alternativen Ausführungsform wird der Schritt S20 vor dem Schritt S10 durchgeführt.

In Schritt S30 wird ein Enable-Signal EN auf der Senderseite 3 für zu übertragende Register 9 aus der maximalen Anzahl von zu übertragenden Registern 9 gesetzt. Das Enable-Signal EN wird bei der Übertragungsrichtung von der FPGA-Applikation 8 zu dem I/O-Modul 5 automatisch aktiviert, sobald ein Datenkanal im dem zugrundeliegenden FPGA Modell verwendet wird. Außerdem wird das Enable-Signal EN von der Senderseite 3 zu der Empfängerseite 4 über die serielle Schnittstelle 6 übertragen, wodurch das adaptive Interface 7 initialisiert wird. Ein Ready-Signal RDY, das als einzelnes Bit implementiert ist, wird anschließend aktiviert.

In Schritt S40 werden die Register 9, für welche das Enable-Signal EN gesetzt ist, von der Senderseite 3 zu der Empfängerseite 4 übermittelt. Dazu wird zunächst das Ready-Signal RDY überprüft. Läuft bereits eine Übertragung, wird dies durch das fehlende Ready-Signal RDY angezeigt, und eine Datenübertragung ist nicht möglich.

Sobald das Ready-Signal RDY anliegt werden die von den jeweiligen FPGA-Applikationen 8 zu übertragenden Daten in die Register 9 geschrieben.

Die Übermittlung der Daten aus den Registern 9 über die serielle Schnittstelle 6 wird von dem FPGA 2 durch das Setzen eines Strobe-Signals Str gestartet. Das Ready-Signal RDY wird entsprechend deaktiviert. Die Implementierung von Strobe- Str und Ready-Signal RDY erfolgt hier als High-Pegel, d.h. als logische Eins.

Beginnend mit dem Strobe-Signal Str werden auf der Senderseite 3 die Daten aus den Registern 9 ausgelesen und übertragen. Anschließend werden die Daten auf der Empfängerseite 4 in die passenden Register 9 eingeschrieben. Danach wird auf der Empfängerseite 4 ein Ready-Signal RDY bereitgestellt um anzuzeigen, dass das Empfangen der Register 9 von der Senderseite 3 abgeschlossen ist, und auf der Empfängerseite 4 liest jede Hardware -Implementierung 10 aus den übertragenen Registern 9 die für sie bestimmten Daten aus.

Bei geänderten Enable-Signalen EN werden diese an die Empfängerseite 4 übertragen. Andernfalls erfolgt direkt das Übertragen der Register 9. Dabei werden Inhalte der Register 9 wie im Weiteren beschrieben reduziert.

Beim Übertragen der Register 9 von der Senderseite 3 zu der Empfängerseite 4 wird zunächst für jedes Register 9 geprüft, ob das Enable-Signal EN gesetzt ist. Ist das Enable-Signal EN nicht gesetzt, wird das Register 9 nicht übertragen, und das nächste Register 9 wird ausgewählt.

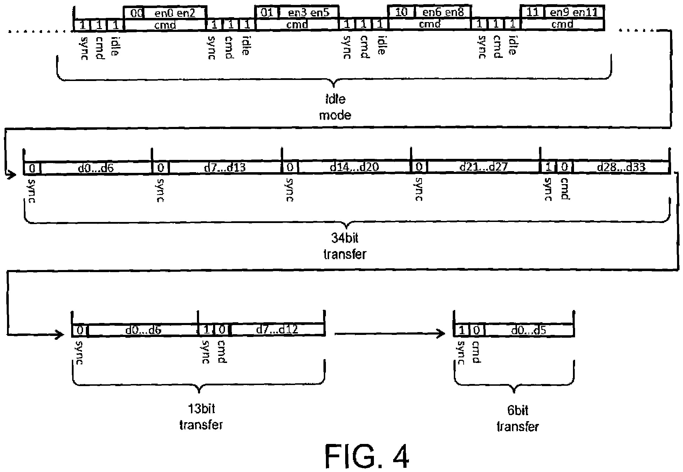

Für die verbleibenden Register 9, für welche das Enable-Signal EN gesetzt ist, werden führende Nullen als gleichartige Führungsbits erfasst. Die gleichartigen Führungsbits werden für jedes Register 9 bei der Übermittlung ausgespart. Es ergibt sich durch das Aussparen der gleichartigen Führungsbits eine Anpassung der Anzahl der zu übertragenden Datenblöcke des LVDS-Interface 6. Bei einer verbleibenden Anzahl von 1 bis 6 zu übertragenden Bits ergibt sich 1 LVDS Datenblock mit 8 Bit, bei 7 bis 13 zu übertragenden Bits ergeben sich 2 LVDS Datenblöcke mit je 8 Bit, bei 14 bis 20 zu übertragenden Bits ergeben sich 3 LVDS Datenblöcke mit je 8 Bit, bei 21 bis 27 zu übertragenden Bits ergeben sich 4 LVDS Datenblöcke mit je 8 Bit und bei 28 bis 34 zu übertragenden Bits ergeben sich 5 LVDS Datenblöcke mit je 8 Bit. Zusätzlich wird in den LVDS Datenblöcken eine Information "weiteres Paket folgt" bzw. "letztes Paket" über ein definiertes Steuerbit übertragen. Weitere Details werden nachstehend unter Bezug auf Fig. 4 erläutert.

Auf Empfängerseite 4 werden nicht empfangene Bits, d.h. die ausgesparten Bits, als empfangene Bits mit dem Wert der gleichartigen Führungsbits ausgegeben, d.h. mit "Null" aufgefüllt. Enthält ein Register 9 nur den Wert "Null", wird die Übertragung des Registers 9 insgesamt auf eine Kontrollstruktur reduziert.

Für die weitere Übertragung von Registern 9 kann auf der Senderseite 3 das Enable-Signal EN für zu übertragende Register 9 aus der maximalen Anzahl von zu übertragenden Registern 9 nach Bedarf verändert und damit dynamisch gesetzt werden. Bei einer Veränderung des Enable-Signals EN wird dies wie oben beschrieben zum Beginn der Übermittlung der Register 9 übertragen. Alternativ erfolgt das Übertragen des Enable-Signals EN von der Senderseite 3 zu einer Empfängerseite 4 in einer Übertragungspause auf der seriellen Schnittstelle 6, d.h. wenn die serielle Schnittstelle 6 in einem IDLE-Mode keine Daten überträgt. Weiter alternativ erfolgt im IDLE-Mode auch eine wiederholte Übertragung des jeweils anliegenden Enable-Signals EN unabhängig von dessen Änderung.

In einer alternativen Ausführungsform werden in die Register 9 Änderungen der Registerinhalte als Daten geschrieben. Eine Änderung eines Wertes wird als Eins signalisiert, ein nicht geändertes Bit wird auf Null gesetzt. Im Übrigen wird das Verfahren wie oben beschrieben durchgeführt.

In einer alternativen Ausführungsform entfällt das oben beschriebene Reduzieren der Inhalte der Register 9. In dieser alternativen Ausführungsform werden somit unabhängig von den Führungsbits alle Register 9, für welche das Enable-Signal EN gesetzt ist, übertragen. Dies wird über ein entsprechendes Kontrollsignal für jedes einzelne Register 9 signalisiert. Dadurch erfolgt ein Synchronisieren von Registerinhalten auf der Sender- und der Empfängerseite 3, 4. Das Synchronisieren erfolgt periodisch. In einer weiteren, alternativen Ausführungsform erfolgt die Synchronisation von Registerinhalten auf der Sender- und der Empfängerseite 3, 4 in Kombination mit dem zuvor beschrieben Übermitteln von Änderungen der Registerinhalte, d.h. beim Übertragen der Änderungen der Registerinhalte erfolgt eine Synchronisierung, indem die vollständigen Registerinhalte übertragen werden.

In einer weiteren alternativen Ausführungsformin wird in jedem Register 9 das Führungsbit als nicht gleichartiges Bit gesetzt, also auf Eins. Dies erzwingt die Übertragung des gesamten Registers 9, so dass das adaptive Interface 7 mit einer konstanten Datenrate arbeitet.

Nachstehend wird unter Bezug auf Fig. 4 ein beispielhafter Ablauf einer Datenübertragung beschrieben.

Nach dem Einschalten befindet sich die serielle Schnittstelle 6 im IDLE-Modus (SYNC = 1, CMD = 1, IDLE = 1). In diesem Modus werden zyklisch und dauerhaft die Zustände der 12 Enable-Signale EN einer FPGA-Applikation 8 an die Empfängerseite 4 übertragen. Die Übertragung aller 12bit benötigt dabei 4 LVDS Datenblöcke mit je 8 Bit und muss nach dem Einschalten mindestens einmal vollständig abgeschlossen sein, damit eine Übertragung der Register 9 von der Senderseite 3 an die Empfängerseite 4 initialisiert ist.

Sobald durch die Senderseite 2 das Strobe-Signal Str gesendet wird, wechselt die Senderseite 3 mit Beginn des nächsten LVDS Datenblocks in einen Übertragungsmodus für die anliegenden I/O Daten in den Registern 9 (SYNC = 0). Nun werden die Register 9 aller Eingangsports beginnend mit Port 1 unmittelbar aufeinanderfolgend übertragen, wobei die Register, für welche das Enable-Signal EN nicht gesetzt ist, übersprungen werden.

Die Übertragung jedes Registers 9 wird auf maximal 4 x 7bit Pakete (SYNC = 0) plus ein abschließendes 6bit Paket (SYNC = 1, CMD = 0) zur Ende-Erkennung aufgeteilt und beginnt mit dem LSB, wie oben beschrieben. Nach Abschluss der Übertragung eines Registers 9 folgt sofort ohne Lücke das nachfolgende Register 9.

Nach der Abarbeitung aller 12 Register 9 fällt der Controller wieder in den IDLE Mode zurück (SYNC = 1, CMD = 1, IDLE = 1) und überträgt erneut zyklisch die Zustände der ENABLE Bit Eingänge.

Die beschriebenen Ausführungsbeispiele betreffen jeweils das FPGA 2 als Senderseite 3 und die I/O-Module 5 als Empfängerseite 4. In einer alternativen Ausführungsform bildet das FPGA 2 die Empfängerseite 4 und die I/O-Module 5 die Senderseite 3. In einer weiter alternativen Ausführungsform ist das adaptive Interface 7 als bidirektionales Interface ausgeführt. Entsprechende werden die Enable-Signale EN durch die Implementierung der I/O-Module 5 in dem FPGA-Modell automatisch gesetzt.

**Bezugszeichenliste**

| | |
|---|---|
| FPGA-Steuerungssystem | 1 |
| FPGA | 2 |
| Senderseite | 3 |
| Empfängerseite | 4 |
| I/O-Modul | 5 |
| serielle Schnittstelle | 6 |
| adaptives Interface | 7 |
| FPGA-Applikation | 8 |
| Register | 9 |
| Hardware-Implementierung | 10 |

## Patentansprüche

1. Verfahren zur Implementierung eines adaptiven Interface (7) zwischen wenigstens einem FPGA (2) mit wenigstens einer FPGA-Applikation (8) und wenigstens einem I/O-Modul (5) zur Verbindung mit dem FPGA (2), die als korrespondierende Senderseite (3) bzw. Empfängerseite (4) ausgebildet sind, wobei zwischen dem wenigstens einen FPGA (2) und dem wenigstens einen I/O-Modul (5) eine serielle Schnittstelle (6) ausgebildet ist, umfassend die Schritte
Konfigurieren einer maximalen Anzahl von zu übertragenden Registern (9) für jede FPGA-Applikation (8),
Konfigurieren einer gemeinsamen, festen Registerbreite für alle Register (9),
Setzen eines Enable-Signals (EN) auf der Senderseite (3) für zu übertragende Register (9) aus der maximalen Anzahl von zu übertragenden Registern (9),
Übertragen des Enable-Signals (EN) von der Senderseite (3) zu der Empfängerseite (4) über die serielle Schnittstelle (6), und
Übertragen der Register (9), für welche das Enable-Signal (EN) gesetzt ist, von der Senderseite (3) zu der Empfängerseite (4) über die serielle Schnittstelle (6).

2. Verfahren nach Anspruch 1, **dadurch gekennzeichnet, dass**
das Übertragen der Register (9), für welche das Enable-Signal (EN) gesetzt ist, von der Senderseite (3) zu der Empfängerseite (4) das Bereitstellen eines Strobe-Signals (Str) auf der Senderseite (3) umfasst, um anzuzeigen, dass die zu übertragenden Register (9) zur Übertragung bereit sind.

3. Verfahren nach einem der Ansprüche 1 oder 2,
**dadurch gekennzeichnet, dass**
das Übertragen der Register (9), für welche das Enable-Signal (EN) gesetzt ist, von der Senderseite (3) zu der Empfängerseite (4) das Bereitstellen eines Ready-Signals (RDY) auf der Senderseite (3) umfasst, um anzuzeigen, dass die Übertragung der Register (9) an die Empfängerseite (4) abgeschlossen ist.

4. Verfahren nach einem der vorhergehenden Ansprüche 1 bis 3,
**dadurch gekennzeichnet, dass**
das Übertragen der Register (9), für welche das Enable-Signal (EN) gesetzt ist, von der Senderseite (3) zu der Empfängerseite (4) das Bereitstellen eines Ready-Signals (RDY) auf der Empfängerseite (4) umfasst, um anzuzeigen, dass das Empfangen der Register (9) von der Senderseite (3) abgeschlossen ist.

5. Verfahren nach einem der vorhergehenden Ansprüche 1 bis 4,
**dadurch gekennzeichnet, dass**
das Übertragen der Register (9), für welche das Enable-Signal (EN) gesetzt ist, von der Senderseite (3) zu der Empfängerseite (4) das Aussparen gleichartiger Führungsbits jedes Registers (9) umfasst.

6. Verfahren nach dem vorhergehenden Anspruch 5,
**dadurch gekennzeichnet, dass**
das das Aussparen gleichartiger Führungsbits jedes Registers (9) das Aussparen von vordefinierten Registerabschnitten mit gleichartigen Führungsbits umfasst.

7. Verfahren nach einem der vorhergehenden Ansprüche 5 oder 6,
**dadurch gekennzeichnet, dass**
das Übertragen der Register (9), für welche das Enable-Signal (EN) gesetzt ist, von der Senderseite (3) zu der Empfängerseite (4) das Hinzufügen eines Führungsbits als nicht gleichartiges Bit umfasst.

8. Verfahren nach einem der vorhergehenden Ansprüche 1 bis 7,
**dadurch gekennzeichnet, dass**
das Übertragen der Register (9), für welche das Enable-Signal (EN) gesetzt ist, von der Senderseite (3) zu der Empfängerseite (4) das Überprüfen von Registern (9), für welche das Enable-Signal (EN) gesetzt ist, auf geänderte Inhalte und das Übertragen von Registern (9) mit geänderten Inhalten umfasst.

9. Verfahren nach Anspruch 8,
**dadurch gekennzeichnet, dass**
das Verfahren das Synchronisieren von Registerinhalten auf der Sender- und der Empfängerseite (3, 4) umfasst.

10. Verfahren nach einem der vorhergehenden Ansprüche 1 bis 9,
**dadurch gekennzeichnet, dass**
das Setzen auf der Senderseite (3) eines Enable-Signals (EN) für zu übertragende Register aus der maximalen Anzahl von zu übertragenden Registern (9) ein dynamisches Setzen des Enable-Signals (EN) vor der Übertragung der Register (9) umfasst, und
das Übertragen des Enable-Signals (EN) von der Senderseite (3) zu der Empfängerseite (4) jeweils vor der Übertragung der Register (9) erfolgt.

11. Verfahren nach einem der vorhergehenden Ansprüche 1 bis 9,
**dadurch gekennzeichnet, dass**
das Setzen auf der Senderseite (3) eines Enable-Signals (EN) für zu übertragende Register (9) aus der maximalen Anzahl von zu übertragenden Registern (9) ein dynamisches Setzen des Enable-Signals (EN) bei einer Veränderung zu übertragender Register (9) umfasst, und
das Übertragen des Enable-Signals (EN) von der Senderseite (3) zu der Empfängerseite (4) jeweils nach einer Veränderung der zu übertragenden Register (9) erfolgt.

12. Verfahren nach einem der vorhergehenden Ansprüche 1 bis 11,
**dadurch gekennzeichnet, dass**
das Übertragen des Enable-Signals (EN) von der Senderseite (3) zu der Empfängerseite (4) in einer Übertragungspause auf der seriellen Schnittstelle (6) erfolgt.

13. Verfahren nach einem der vorhergehenden Ansprüche 1 bis 12,
**dadurch gekennzeichnet, dass**
das Verfahren den zusätzlichen Schritt des Hinzufügens eines generischen Funktionsblocks zur Senderseite (3) wie auch zur Empfängerseite (4) umfasst.

14. Verfahren nach einem der vorhergehenden Ansprüche 1 bis 13,
**dadurch gekennzeichnet, dass**
das Verfahren den zusätzlichen Schritt des automatischen Ermittelns eine Konfiguration für das adaptive Interface (7) umfasst.

15. FPGA-Steuerungssystem (1) mit wenigstens einem FPGA (2) mit wenigstens einer FPGA-Applikation (8) und wenigstens einem I/O-Modul (5) zur Verbindung mit dem FPGA (2), die als korrespondierende Senderseite (3) bzw. Empfängerseite (4) ausgebildet sind, wobei zwischen dem wenigstens einen FPGA (2) und dem wenigstens einen I/O-Modul (5) eine serielle Schnittstelle (6) ausgebildet ist, wobei das FPGA-Steuerungssystem (1) zur Implementierung eines adaptiven Interface (7) zwischen dem wenigstens einen FPGA (2) und dem wenigstens einem I/O-Modul (5) nach einem der vorhergehenden Ansprüche ausgebildet ist.

## Claims

1. A method for implementing an adaptive interface (7) between at least one FPGA (2), which has at least one FPGA application (8), and at least one I/O module (5) for connection to the FPGA (2), said FPGA and module being designed as a corresponding sender side (3) and receiver side (4) respectively, wherein a serial interface (6) is formed between the at least one FPGA (2) and the at least one I/O module (5), the method comprising the steps of:
configuring a maximum number of registers (9) to be transmitted for each FPGA application (8),
configuring a shared, fixed register width for all registers (9),
setting an enable signal (EN) on the sender side (3) for the registers (9) to be transmitted from the maximum number of registers (9) to be transmitted,
transmitting the enable signal (EN) from the sender side (3) to the receiver side (4) via the serial interface (6), and
transmitting the registers (9) for which the enable signal is set (EN) from the sender side (3) to the receiver side (4) via the serial interface (6).

2. The method according to claim 1, **characterised in that** the transmission of the registers (9) for which the enable signal (EN) is set, from the sender side (3) to the receiver side (4), comprises providing a strobe signal (Str) on the sender side (3) to indicate that the registers (9) to be transmitted are ready for transmission.

3. The method according to either one of claims 1 or 2, **characterised in that**
the transmission of the registers (9) for which the enable signal (EN) is set, from the sender side (3) to the receiver side (4), comprises providing a ready signal (RDY) on the sender side (3) to indicate that the transmission of the registers (9) to the receiver side (4) has been completed.

4. The method according to any one of claims 1 to 3, **characterised in that**
the transmission of the registers (9), for which the enable signal (EN) is set, from the sender side (3) to the receiver side (4), comprises providing a ready signal (RDY) on the receiver side (4) to indicate that the receiving of the registers (9) from the sender side (3) has been completed.

5. The method according to any one of claims 1 to 4, **characterised in that**
the transmission of the registers (9) for which the enable signal (EN) is set, from the sender side (3) to the receiver side (4), comprises the omission of equal leading bits of each register (9).

6. The method according to claim 5,
**characterised in that**
the omission of equal leading bits of each register (9) comprises the omission of predefined register sections with equal leading bits.

7. The method according to either one of claims 5 or 6, **characterised in that**
the transmission of the registers (9) for which the enable signal (EN) is set, from the sender side (3) to the receiver side (4), comprises the addition of a leading bit as an unequal bit.

8. The method according to any one of claims 1 to 7, **characterised in that**
the transmission of the registers (9) for which the enable signal (EN) is set, from the sender side (3) to the receiver side (4), comprises the checking of registers (9) for which the enable signal (EN) is set for changed contents and the transmission of registers (9) with the changed contents.

9. The method according to claim 8,
**characterised in that**
the method comprises the synchronisation of register contents on the sender and receiver side (3, 4).

10. The method according to any one of claims 1 to 9, **characterised in that**
the setting on the sender side (3) of an enable signal (EN) for registers to be transmitted from the maximum number of registers (9) to be transmitted comprises a dynamic setting of the enable signal (EN) before the transmission of the registers (9), and
the transmission of the enable signal (EN) from the sender side (3) to the receiver side (4) occurs in each case before the transmission of the registers (9).

11. The method according to any one of claims 1 to 9, **characterised in that**
the setting on the sender side (3) of an enable signal (EN) for registers (9) to be transmitted from the maximum number of registers (9) to be transmitted comprises a dynamic setting of the enable signal (EN) in the case of a change in registers (9) to be transmitted, and
the transmission of the enable signal (EN) from the sender side (3) to the receiver side (4) occurs in each case after a change in the registers (9) to be transmitted.

12. The method according to any one of claims 1 to 11, **characterised in that**
the transmission of the enable signal (EN) from the sender side (3) to the receiver side (4) occurs in a transmission pause in the serial interface (6).

13. The method according to any one of claims 1 to 12, **characterised in that**
the method comprises the additional step of adding a generic function block to the sender side (3) and to the receiver side (4).

14. The method according to any one of claims 1 to 13, **characterised in that**
the method comprises the additional step of automatically determining a configuration for the adaptive interface (7).

15. An FPGA control system (1) comprising at least one FPGA (2), which has at least one FPGA application (8), and at least one I/O module (5) for connection to the FPGA (2), said FPGA and module being designed as a corresponding sender side (3) and receiver side (4) respectively, wherein a serial interface (6) is formed between the at least one FPGA (2) and the at least one I/O module (5), wherein the FPGA control system (1) is configured to implement an adaptive interface (7) between the at least one FPGA (2) and the at least one I/O module (5) according to any one of the preceding claims.

## Revendications

1. Procédé pour la mise en oeuvre d'une interface (7) adaptative entre au moins un circuit logique programmable FPGA (2) avec au moins une application de FGPA (8) et au moins un module entrée/sortie I/O (5) pour la liaison avec le FPGA (2), qui sont conçus en tant que coté émetteur (3), respectivement côté récepteur (4) correspondants, où il y a une interface (6) de série entre l'au moins un FGPA (2) et l'au moins un module I/O (5), comprenant les étapes
de configuration d'un nombre maximal de registres (9) à transmettre pour chaque application de FPGA (8),
de configuration d'une largeur de registre fixe commune pour tous les registres (9),
de fixation d'un signal de validation (EN) sur le côté émetteur (3) pour des registres (9) à transmettre à partir du nombre maximal de registres (9) à transmettre,
de transmission du signal de validation (EN) du côté émetteur (3) vers le côté récepteur (4) par l'intermédiaire de l'interface (6) de série, et
de transmission des registres (9), pour lesquels le signal de validation (EN) a été fixé, du côté émetteur (3) vers le côté récepteur (4) par l'intermédiaire de l'interface (6) de série.

2. Procédé selon la revendication 1, **caractérisé en ce que**
la transmission des registres (9), pour lesquels le signal de validation (EN) est fixé, du côté émetteur (3) vers le côté récepteur (4), comprend la mise en oeuvre d'un signal stroboscopique (Str) sur le côté émetteur (3) afin d'indiquer que les registres (9) à transmettre sont prêts pour la transmission.

3. Procédé selon l'une des revendications 1 ou 2,
**caractérisé en ce que**
la transmission des registres (9) pour lesquels le signal de validation (EN) est fixé, du côté émetteur (3) vers le côté récepteur (4), comprend la mise en oeuvre d'un signal d'opération (RDY) sur le côté émetteur (3) afin d'indiquer que la transmission des registres (9) est réalisée du côté récepteur (4).

4. Procédé selon l'une des revendications précédentes 1 à 3,
**caractérisé en ce que**
la transmission des registres (9) pour lesquels le signal de validation (EN) est fixé, du côté émetteur (3) vers le côté récepteur (4), comprend la mise en oeuvre d'un signal d'opération (RDY) sur le côté récepteur (4) afin d'indiquer que la réception des registres (9) est réalisée du côté émetteur (3).

5. Procédé selon l'une des revendications précédentes 1 à 4,
**caractérisé en ce que**
la transmission des registres (9) pour lesquels le signal de validation (EN) est fixé, du côté émetteur (3) vers le côté récepteur (4), comprend la mise de côté de bits de guidage du même type de chaque registre (9).

6. Procédé selon la revendication précédente 5,
**caractérisé en ce que**
la mise de côté de bits de guidage du même type de chaque registre (9) comprend la mise de côté de sections de registre prédéfinies avec des bits de guidage du même type.

7. Procédé selon l'une des revendications précédentes 5 ou 6,
**caractérisé en ce que**
la transmission des registres (9), pour lesquels le signal de validation (EN) est fixé, du côté émetteur (3) vers le côté récepteur (4), comprend l'ajout d'un bit de guidage en tant que bit n'étant pas du même type.

8. Procédé selon l'une des revendications précédentes 1 à 7,
**caractérisé en ce que**
la transmission des registres (9) pour lesquels le signal de validation (EN) est fixé, du côté émetteur (3) vers le côté récepteur (4), comprend la vérification de registres (9), pour lesquels le signal de validation (EN) est fixé, concernant des contenus modifiés et la transmission de registres (9) avec des contenus modifiés.

9. Procédé selon la revendication 8,
**caractérisé en ce que**
le procédé comprend la synchronisation de contenus de registres avec la page d'émission et de la page de réception (3, 4).

10. Procédé selon l'une des revendications précédentes 1 à 9,
**caractérisé en ce que**
la fixation d'un signal de validation (EN) sur la page d'émetteur (3) pour des registres à transmettre à partir du nombre maximal de registres (9) à transmettre comprend une fixation dynamique du signal de validation (EN) avant la transmission des registres (9), et
la transmission du signal de validation (EN) à partir de la page d'émetteur (3) vers la page de récepteur (4) est respectivement effectuée avant la transmission des registres (9).

11. Procédé selon l'une des revendications précédentes 1 à 9,
**caractérisé en ce que**
la fixation d'un signal de validation (EN) sur la page d'émetteur (3) pour des registres (9) à transmettre à partir du nombre maximal de registres (9) à transmettre comprend une fixation dynamique du signal de validation (EN) lors d'une modification des registres (9) à transmettre, et
la transmission du signal de validation (EN) à partir du côté émetteur (3) vers le côté récepteur (4) est respectivement effectuée après une modification des registres (9) à transmettre.

12. Procédé selon l'une des revendications précédentes 1 à 11,
**caractérisé en ce que**
la transmission du signal de validation (EN) à partir du côté émetteur (3) vers le côté récepteur (4) pendant une pause de transmission est effectuée sur l'interface (6) de série.

13. Procédé selon l'une des revendications précédentes 1 à 12,
**caractérisé en ce que**
le procédé comprend l'étape supplémentaire de l'ajout d'un bloc de fonction générique du côté émetteur (3), ainsi que du côté récepteur (4).

14. Procédé selon l'une des revendications précédentes 1 à 13,
**caractérisé en ce que**
le procédé comprend l'étape supplémentaire de la détermination automatique d'une configuration pour l'interface (7) adaptative.

15. Système de commande FPGA (1) avec au moins un circuit FPGA (2) avec au moins une application de FPGA (8) et au moins un module I/O (5) pour la liaison avec le FPGA (2), qui sont conçus sous la forme de page d'émetteur (3), respectivement de page de récepteur (4) correspondantes, où entre l'au moins un FPGA (2) et l'au moins un module I/O (5), il y a une interface (6) de série, où le système de commande FPGA (1) est conçu pour la mise en oeuvre d'une interface (7) adaptative entre l'au moins un FPGA (2) et l'au moins un module I/O (5) selon l'une des revendications précédentes.
